# EUROPEAN PATENT APPLICATION

(11) **EP 4 343 830 A1**
(43) Date of publication of application: **27.03.2024**
(21) Application number: 22828042.6
(22) Date of filing: 04.04.2022
(51) Int. Cl.: H01L 23/473, G06F 1/20, H05K 7/20

(54) **COOLING COMPONENT AND DEVICE**

(30) Priority: 21.06.2021 JP 2021102169
(71) Applicant: NEC Platforms, Ltd., Kanagawa 213-8511 (JP)
(72) Inventor: ISOYA, Satoshi, Kawasaki-shi, Kanagawa 213-8511 (JP)
(74) Representative: Vossius & Partner Patentanwälte Rechtsanwälte mbB
(86) International application number: PCT/JP2022/017021
(87) International publication number: WO 2022/270123

(57) **Abstract**

Provided are: a cooling component which, when one region of an object to be cooled is cooled with priority, is capable of efficiently cooling another region of the object to be cooled using a refrigerant used in the cooling of the object to be cooled; and a device. The cooling component cools the object to be cooled that includes a high-temperature region and another region. Inside the cooling component, disposed is a flow passage through which the refrigerant that is supplied from a supply port and discharged toward a discharge port flows. The cooling component includes a cooling part opposing the high-temperature region and another cooling part opposing the other region. The flow passage includes: a refrigerant supply passage that includes an upstream-side passage disposed inside the cooling part opposing the high-temperature region and that cools the high-temperature region by the refrigerant supplied from the supply port; a connecting passage that connects to the refrigerant supply passage and that is disposed at a position further from the object to be cooled than the upstream-side passage; and a refrigerant discharge passage that is disposed inside the other cooling part, that includes a downstream-side passage connected to the connecting passage, that cools the other region by the refrigerant, and that discharges the refrigerant to the discharge port.

## Description

### Technical Field

The present disclosure relates to a cooling component and a device.

### Background Art

There is a cooling component that receives heat from an electronic component that generates heat and cools the electronic component. PTL 1 describes that in a cooling component, a refrigerant is first supplied to a portion having a high heat generation density of a heat generating component, and the refrigerant that has cooled the portion having a high heat generation density of the heat generating component is supplied to another portion of the heat generating component.

PTL 2 describes that an inflow nozzle that supplies a refrigerant is disposed perpendicular to and at a central portion of a plate-shaped fin of a heat absorbing portion that draws heat of an object to be cooled.

PTL 3 describes a cooling component in which a contact layer connected to a heat source is formed and a passage for supplying a refrigerant to the contact layer and a passage for collecting the refrigerant from the contact layer are formed above the contact layer. In addition, it is described that, in the cooling component, the refrigerant is supplied to a plurality of places of the contact layer, and the refrigerant is removed from a plurality of other places in the contact layer.

PTL 4 describes that a cooling component cools a central portion of an electronic component preferentially, and then cools an entire surface of the electronic component to a uniform temperature in a process of passing through a passage formed along a bottom surface of the cooling component in a spiral or meandering pattern.

### Citation List

### Patent Literature

PTL 1: JP 2014-183072 A
PTL 2: JP 2007-180505 A
PTL 3: JP 2006-517728 W
PTL 4: JP 08-241943 A

### Summary of Invention

### Technical Problem

However, in the cooling component described in PTL 1, the refrigerant whose temperature has increased due to the heat received from the portion having a high heat generation density of the heat generating component passes through a passage formed along a bottom surface of the cooling component in contact with the heat generating component, and cools another portion of the heat generating component. In the cooling component, the refrigerant also receives heat while passing through the passage formed along the bottom surface of the cooling component in contact with the heat generating component, and thus the temperature of the refrigerant further increases. As described above, in the cooling component described in PTL 1, when a portion having a high heat generation density of the heat generating component is preferentially cooled, the another region of the heat generating component cannot be efficiently cooled using the refrigerant used for cooling the portion having a high heat generation density of the heat generating component.

In the cooling device described in PTL 2, the refrigerant is supplied from the inflow nozzle to the central portion of the fin, and the refrigerant passes toward both ends of the fin. Since the refrigerant receives heat while the refrigerant passes toward both ends of the fin, the temperature of the refrigerant rises at the end of the fin. Therefore, in the cooling device described in PTL 2, when the portion facing the central portion of the fin is preferentially cooled in the object to be cooled, the other region of the object to be cooled cannot be efficiently cooled using the refrigerant used for cooling.

In the cooling component described in PTL 3, the refrigerant supplied to the contact layer flows through the contact layer, is collected in a passage formed above the contact layer, and is discharged to the outside of the cooling component. As described above, since the refrigerant that has cooled the region having the heat source is not used again for cooling, the cooling component described in PTL 3 cannot efficiently cool the other region of the heat source by using the refrigerant used for cooling the heat source when the region having the heat source is preferentially cooled.

In addition, in the cooling component described in PTL 4, the refrigerant whose temperature has increased due to heat received from the central portion of the electronic component cools other portions of the electronic component while passing through a passage formed along the bottom surface of the cooling component. In the cooling component, since the refrigerant receives heat from the electronic component even while passing through the passage formed along the bottom surface, the temperature of the refrigerant further increases. As described above, in the cooling component described in PTL 4, when the central portion of the electronic component is preferentially cooled, a region other than the central portion of the electronic component cannot be efficiently cooled using the refrigerant that has cooled the electronic component.

As described above, in the cooling components described in PTLS 1 to 4, when a certain region of the cooling target is preferentially cooled, there is a problem that the other region of the cooling target cannot be efficiently cooled using the refrigerant used for cooling the cooling target.

An object of the present disclosure is to provide a cooling component and a device capable that when a certain region of the cooling target is preferentially cooled, another region of the cooling target can be efficiently cooled by reusing the refrigerant used for cooling the cooling target.

### Solution to Problem

One aspect of the present disclosure is a cooling component that cools a cooling target including a high-temperature region that rises to a higher temperature by heat generation and another region that rises to a temperature lower than that of the high-temperature region by heat generation, and internally includes a passage through which a refrigerant supplied from an upstream-side supply port and discharged toward a downstream-side discharge port flows, the cooling component including a cooling section facing the high-temperature region and another cooling section facing the another region, in which the passage includes a refrigerant supply passage that includes an upstream-side passage disposed inside the cooling section facing the high-temperature region and cools the high-temperature region by the refrigerant supplied from the supply port, a connecting passage connected to the refrigerant supply passage, and a refrigerant discharge passage that includes a downstream-side passage disposed in the another cooling section and connected to the connecting passage, cools the another region with the refrigerant supplied from the connecting passage, and discharges the refrigerant to the discharge port, and the connecting passage is disposed at a position farther away from the cooling target than the upstream-side passage. Advantageous Effects of Invention

According to the cooling component of the present disclosure, when a certain region of the cooling target is preferentially cooled, another region of the cooling target can be efficiently cooled by reusing the refrigerant used for cooling the cooling target.

### Brief Description of Drawings

[Fig. 1] Fig. 1 is a transparent perspective view illustrating a configuration example of a cooling component according to a first example embodiment of the present disclosure.
[Fig. 2] Fig. 2 is a transparent exploded perspective view illustrating a configuration example of a device including the cooling component and a cooling target according to the first example embodiment of the present disclosure.
[Fig. 3] Fig. 3 is a transparent exploded perspective view illustrating a configuration example of a device including a cooling component and a cooling target according to a second example embodiment of the present disclosure.
[Fig. 4] Fig. 4 is an exploded perspective view of the cooling component according to the second example embodiment of the present disclosure.
[Fig. 5] Fig. 5 is a cross-sectional view taken along the line V-V of the device illustrated in Fig. 3.
[Fig. 6] Fig. 6 is a cross-sectional view taken along the line VI-VI of Fig. 3, illustrating the layered structure below a cooling passage forming layer and the cooling target in the cooling component of the second example embodiment, and illustrating the direction in which a refrigerant flows in an upstream-side passage.
[Fig. 7] Fig. 7 is a cross-sectional view taken along the line VII-VII of Fig. 3, illustrating the layered structure below a second intermediate layer and the cooling target in the cooling component according to the second example embodiment, and illustrating the direction in which the refrigerant flows in a connecting passage.
[Fig. 8] Fig. 8 is a cross-sectional view taken along the line VI-VI of Fig. 3, illustrating the layered structure below the cooling passage forming layer and the cooling target in the cooling component of the second example embodiment, and illustrating the direction in which a refrigerant flows in a downstream-side passage.
[Fig. 9] Fig. 9 is a cross-sectional view taken along the line IX-IX in Fig. 3, illustrating the layered structure below a fourth intermediate layer and the cooling target in the cooling component of the second example embodiment, and illustrating the refrigerant flow direction in a refrigerant discharge passage.
[Fig. 10] Fig. 10 is a three-dimensional view of the device illustrated in Fig. 3.

### Example Embodiment

### [First Example Embodiment]

A first example embodiment of the present disclosure will be described.

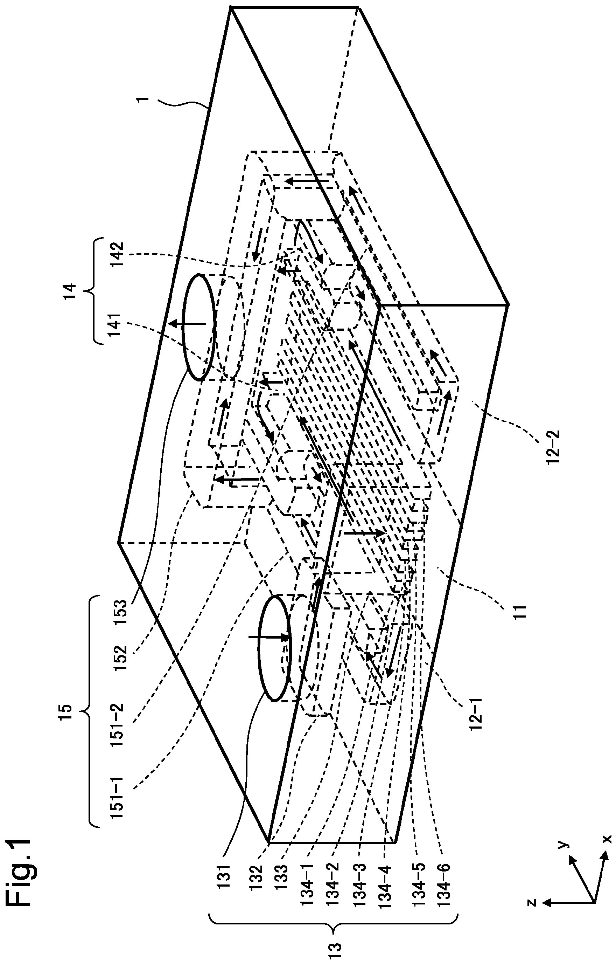

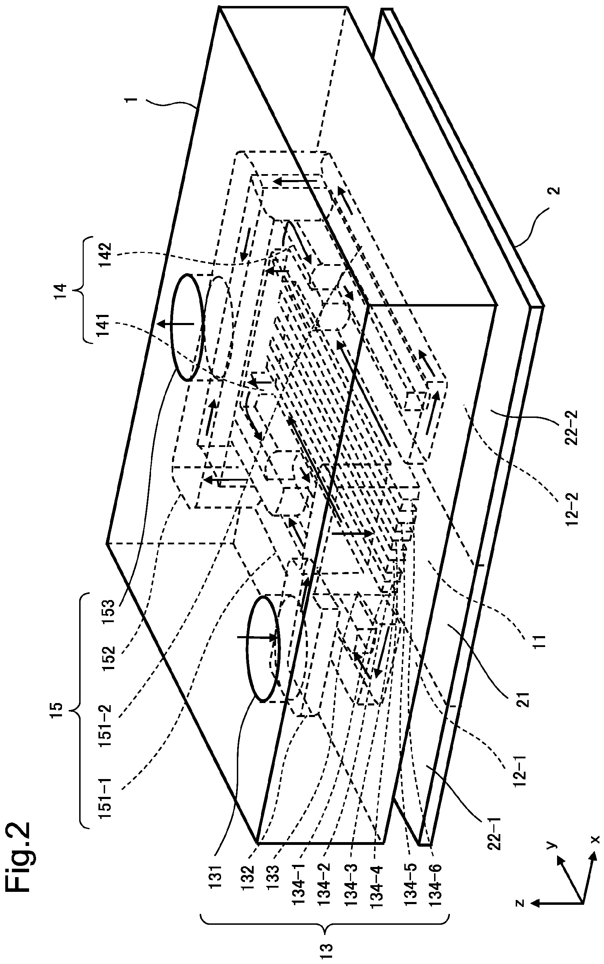

Fig. 1 is a transparent perspective view illustrating a configuration example of a cooling component 1 according to the present example embodiment. Fig. 2 is a transparent exploded perspective view illustrating a configuration example of a device including the cooling component 1 and a cooling target 2 according to the present example embodiment. In Figs. 1 and 2, the xyz axes are illustrated. The x-axis is a direction in which a high-temperature region 21, another region 22-1, and another region 22-2 of the cooling target 2 described later are arranged. The y-axis is a direction perpendicular to the x-axis, and is a direction in which the high-temperature region 21, the another region 22-1, and the another region 22-2 of the cooling target 2 extend. The z-axis is a direction perpendicular to the x-axis and the y-axis. The z-axis is a direction parallel to the height direction of the cooling component 1. In the following description, a direction indicated by each arrow of the xyz axes is a positive direction. Further, in the following description, a direction opposite to the positive direction indicated by each arrow of the xyz axes is referred to as a negative direction. The arrows in the cooling component 1 in Figs. 1 and 2 schematically indicate a direction in which a cooling medium (refrigerant) flows.

Figs. 1 and 2 illustrates the arrows that indicate the flow of the refrigerant passing through an upstream-side passage 134-1 to be described later and the arrows that indicate the flow of the refrigerant passing through the upstream-side passage 134-6. Further, Figs. 1 and 2 do not illustrate arrows that indicate the flow of the refrigerant passing through upstream-side passages 134-2 to 134-5.

As illustrated in Fig. 2, the cooling component 1 of the present example embodiment internally includes passages through which the refrigerant flows such that the refrigerant cools the cooling target 2 as being supplied from an upstream-side supply port 131 and discharged toward a downstream-side discharge port 153. The passages are, for example, an internal space of the cooling component 1. The cooling target 2 includes a high-temperature region 21 that rises to a higher temperature due to heat generation, and another regions 22-1 and 22-2 that rises to a temperature lower than that of the high-temperature region 21 due to heat generation. It can also be said that the high-temperature region 21 of the cooling target 2 is a region having a higher temperature than the another regions 22-1 and 22-2 of the cooling target 2. It can also be said that the high-temperature region 21 of the cooling target 2 is a region having a higher heat generation density than the another regions 22-1 and 22-2 of the cooling target 2. In Fig. 2, the boundaries between the high-temperature region 21 and the another regions 22-1 and 22-2 are schematically indicated by the broken lines.

The cooling component 1 includes a cooling section 11 facing the high-temperature region 21 of the cooling target 2 and another cooling sections 12-1 and 12-2. The another cooling section 12-1 faces the another region 22-1 of the cooling target 2. The another cooling section 12-2 faces the another region 22-2 of the cooling target 2.

The passages disposed in the cooling component 1 includes a refrigerant supply passage 13, a connecting passage 14, and a refrigerant discharge passage 15.

The cooling component 1 is manufactured, for example, by sequentially laminating two or more layers in which the refrigerant supply passage 13, the connecting passage 14, and the refrigerant discharge passage 15 are formed.

The refrigerant supply passage 13 includes upstream-side passages 134-1, 134-2, 134-3, 134-4, 134 -5, and 134-6 disposed inside the cooling section 11 facing the high-temperature region 21 of the cooling target 2. The refrigerant supply passage 13 cools the high-temperature region 21 of the cooling target 2 by the refrigerant supplied from the supply port 131.

Specifically, the refrigerant supply passage 13 includes the supply port 131, a rectangular passage 132, a rectangular passage 133, and the upstream-side passages 134-1 to 134-6.

The supply port 131 is an opening disposed on the upper surface of the cooling component 1. For example, the supply port 131 has an opening in a circular shape in the cross section parallel to the xy plane.

The rectangular passage 132 is a flow passage formed along the xy plane. The rectangular passage 132 is disposed below the supply port 131. The length of one side of the bottom surface and the top surface of the space forming the rectangular passage 132 is longer than the diameter of the circular opening of the supply port 131.

The rectangular passage 133 is a passage formed along the xz plane. The position of the upper surface of the space forming the rectangular passage 133 is relevant to the position of the upper surface of the space forming the rectangular passage 132. In addition, the length in the z-axis direction of the space forming the rectangular passage 133 is longer than the length in the z-axis direction of the space forming the rectangular passage 132. The rectangular passage 133 is formed on one end of the upstream-side passages 134-1 to 134-6. Specifically, the rectangular passage 133 is disposed on the opposite side to a rectangular passage 141 described later and is disposed on one end of the upstream-side passages 134-1 to 134-6. The rectangular passage 133 is connected to each of the upstream-side passages 134-1 to 134-6.

Each of the upstream-side passages 134-1 to 134-6 is a rectangular passage formed along the yz plane. Each of the upstream-side passages 134-1 to 134-6 is a passage disposed inside the cooling section 11 facing the high-temperature region 21 of the cooling target 2. For example, each of the upstream-side passages 134-1 to 134-6 is partitioned by a plate-like member formed along the yz plane. Each of the upstream-side passages 134-1 to 134-6 is connected to the rectangular passage 141 of the connecting passage 14 described later.

The connecting passage 14 is connected to the refrigerant supply passage 13. The connecting passage 14 is disposed at a position farther away from the cooling target 2 than the upstream-side passages 134-1 to 134-6. The distance is, for example, a distance in the z-axis direction.

Specifically, the connecting passage 14 includes the rectangular passage 141 and a U-shaped passage 142.

For example, the rectangular passage 141 is a passage formed along the xy plane. The rectangular passage 141 is disposed on the opposite side of the rectangular passage 133 and is disposed on the ends of the upstream-side passages 134-1 to 134-6. The upper surface of the space forming the rectangular passage 141 is connected to the U-shaped passage 142.

The U-shaped passage 142 includes one rectangular passage formed along the xy plane on the rectangular passage 141 and having a longitudinal direction parallel to the x-axis and two rectangular passages formed along the xy plane and having a longitudinal direction parallel to the y-axis. In the U-shaped passage 142, the one rectangular passage parallel to the x-axis and the two rectangular passages parallel to the y - axis are connected to each other to form the U-shaped passage.

In the U-shaped passage 142, a space formed along the xy plane is disposed in the rectangular passage 141 below a space formed along the xy plane. The space where the U-shaped passage 142 is formed and the space where the rectangular passage 141 is formed are connected to each other. In the U-shaped passage 142, one of the two rectangular passages parallel to the y-axis is connected to a downstream-side passage 151-1. In the U-shaped passage 142, the other of the two rectangular passages parallel to the y-axis is connected to a downstream-side passage 151-2. The downstream-side passages 151-1 and 151-2 constituting a part of the refrigerant discharge passage 15 are disposed below the U-shaped passage 142.

The refrigerant discharge passage 15 includes the downstream-side passages 151-1 and 151-2 disposed inside the another cooling sections 12-1 and 12-2 and connected to the connecting passage 14. The refrigerant discharge passage 15 cools the another regions 22-1 and 22-2 by the refrigerant supplied from the connecting passage 14, and discharges the refrigerant to the discharge port 153.

Specifically, the refrigerant discharge passage 15 includes the downstream-side passages 151-1 and 151-2, a U-shaped passage 152, and the discharge port 153.

The downstream-side passage 151-1 is a passage disposed inside the another cooling section 12-1 and connected to the U-shaped passage 142 of the connecting passage 14. The downstream-side passage 151-2 is a flow passage disposed inside the another cooling section 12-2 and connected to the U-shaped passage 142 of the connecting passage 14. For example, each of the downstream-side passages 151-1 and 151-2 is a U-shaped passage including one rectangular passage formed along the xy plane and having a longitudinal direction parallel to the x-axis and two rectangular passages formed along the xy plane and having a longitudinal direction parallel to the y-axis. In the downstream-side passages 151-1 and 151-2, the one rectangular passage parallel to the x-axis and the two rectangular passages parallel to the y-axis are connected to each other to form a U-shaped passage.

In each of the downstream-side passages 151-1 and 151-2, one of both ends of the two rectangular passages parallel to the y-axis is connected to the U-shaped passage 142. In each of the downstream-side passages 151-1 and 151-2, the other of the both ends of the two rectangular passages parallel to the y-axis is connected to the U-shaped passage 152. The U-shaped passage 152 is disposed above the downstream-side passages 151-1 and 151-2.

The U-shaped passage 152 includes one rectangular passage formed along the xy plane and having a longitudinal direction parallel to the x-axis, and two rectangular passages formed along the yz plane and each connected to the downstream-side passages 151-1 and 151-2. In the U-shaped passage 152, the one rectangular passage along the xy plane and the two rectangular passages along the yz plane are connected to each other to form the U-shaped passage.

In the U-shaped passage 152, an upper surface of a space forming the one rectangular passage along the xy plane and a portion facing the discharge port 153 to be described later are connected to the discharge port 153.

The discharge port 153 is an opening disposed on the upper surface of the cooling component 1. The opening of the discharge port 153 has a circular cross section parallel to the xy plane. The refrigerant is discharged from the discharge port 153 to the outside of the cooling component 1.

The flow of the refrigerant passing through the cooling component 1 will be described. Along the flow of the refrigerant passing through the cooling component 1, first, the flow of the refrigerant passing through the refrigerant supply passage 13 will be described, next, the flow of the refrigerant passing through the connecting passage 14 will be described, and then, the flow of the refrigerant passing through the refrigerant discharge passage 15 will be described.

First, the flow of the refrigerant passing through the refrigerant supply passage 13 will be described.

The refrigerant supplied from the supply port 131 to the rectangular passage 132 passes through the rectangular passage 132 in the positive x-axis direction, and is discharged to the rectangular passage 133. The refrigerant supplied from the rectangular passage 132 to the rectangular passage 133 passes through the rectangular passage 133 in the negative z-axis direction, and is discharged from the rectangular passage 133 to each of the upstream-side passages 134-1 to 134-6. The refrigerant supplied from the rectangular passage 133 to each of the upstream-side passages 134-1 to 134-6 passes through each of the upstream-side passages 134-1 to 134-6 in the positive y-axis direction. Furthermore, the refrigerant is discharged to the rectangular passage 141 connected to each of the upstream-side passages 134-1 to 134-6 on the end in the positive y-axis direction of each of the upstream-side passages 134-1 to 134-6.

Next, a flow of the refrigerant passing through the connecting passage 14 will be described.

The refrigerant supplied from each of the upstream-side passages 134-1 to 134-6 to the rectangular passage 141 passes through the rectangular passage 141 in the positive z-axis direction, and is discharged from the rectangular passage 141 to the U-shaped passage 142. The refrigerant supplied from the rectangular passage 141 to the U-shaped passage 142 is diverted in two directions.

Specifically, the refrigerant supplied from the rectangular passage 141 to the U-shaped passage 142 passes through the U-shaped passage 142 in the positive x-axis direction or the negative x-axis direction. The refrigerant that has passed through the U-shaped passage 142 in the negative x-axis direction passes through the U-shaped passage 142 in the negative y-axis direction, and is discharged to the downstream-side passage 151-1 disposed below the U-shaped passage 142. The refrigerant that has passed through the U-shaped passage 142 in the positive x-axis direction passes through the U-shaped passage 142 in the negative y-axis direction, and is discharged to the downstream-side passage 151-2 disposed below the U-shaped passage 142.

Next, a flow of the refrigerant passing through the refrigerant discharge passage 15 will be described.

First, the following will describe the flow of the refrigerant that the refrigerant discharged to the downstream-side passage 151-1 is discharged from the discharge port 153 to the outside of the cooling component 1.

The refrigerant supplied from the U-shaped passage 142 to the U-shaped downstream-side passage 151-1 passes through the downstream-side passage 151-1. The refrigerant having passed through the downstream-side passage 151-1 is discharged to the U-shaped passage 152 disposed above the downstream-side passage 151-1. The refrigerant supplied from the downstream-side passage 151-1 to the U-shaped passage 152 flows through the U-shaped passage 152 in the positive x-axis direction. Then, the refrigerant is discharged from the discharge port 153 to the outside of the cooling component 1.

Next, the following will describe a flow of the refrigerant that the refrigerant discharged to the downstream-side passage 151-2 is discharged from the discharge port 153 to the outside of the cooling component 1.

The refrigerant supplied from the U-shaped passage 142 to the U-shaped downstream-side passage 151-2 passes through the downstream-side passage 151-2. The refrigerant having passed through the downstream-side passage 151-2 is discharged to the U-shaped passage 152 disposed above the downstream-side passage 151-2. The refrigerant supplied from the downstream-side passage 151-2 to the U-shaped passage 152 flows through the U-shaped passage 152 in the negative x-axis direction. Then, the refrigerant is discharged from the discharge port 153 to the outside of the cooling component 1.

As described above, according to the first example embodiment of the present disclosure, the cooling component 1 cools the cooling target 2 including the high-temperature region 21 and the another regions 22-1 and 22-2, and the passage through which the refrigerant supplied from the upstream-side supply port 131 and discharged toward the downstream-side discharge port 153 flows is disposed inside. The cooling component 1 includes the cooling section 11 facing the high-temperature region 21 of the cooling target 2 and the another cooling sections 12-1 and 22-2 facing the another regions 22-1 and 12-2 of the cooling target 2. In the cooling component 1, the passage includes the refrigerant supply passage 13, the connecting passage 14, and the refrigerant discharge passage 15. In the cooling component 1, the refrigerant supply passage 13 includes the upstream-side passages 134-1 to 134-6 arranged inside the cooling section 11, and cools the high-temperature region 21 of the cooling target 2 by the refrigerant supplied from the supply port 131. In the cooling component 1, the connecting passage 14 is connected to the refrigerant supply passage 13. In the cooling component 1, the refrigerant discharge passage 15 includes the downstream-side passages 151-1 and 151-2 disposed inside the another cooling sections 12-1 and 12-2 and connected to the connecting passage 14. In the cooling component 1, the refrigerant discharge passage 15 cools the another regions 22-1 and 22-2 of the cooling target 2 by the refrigerant supplied from the connecting passage 14, and discharges the refrigerant to the discharge port 153. In the cooling component 1, the connecting passage 14 is disposed at a position farther away from the cooling target 2 than the upstream-side passages 134-1 to 134-6. With this configuration, the refrigerant having passed through the upstream-side passages 134-1 to 134-6 passes through the connecting passage 14, and then is supplied to each of the downstream-side passages 151-1 and 151-2 arranged inside the another cooling sections 12-1 and 12-2. The temperature inside the cooling component 1 decreases as the distance from the cooling target 2 increases. The connecting passage 14 is disposed at a position farther away from the cooling target 2 than the upstream-side passages 134-1 to 134-6. Therefore, as the refrigerant passes through the connecting passage 14, the temperature of the refrigerant becomes lower than the temperature of the refrigerant when flowing into the connecting passage 14. Therefore, when a certain region (the high-temperature region 21 in the present example embodiment) of the cooling target 2 is preferentially cooled, the another region (the another regions 22-1 and 22-2 in the present embodiment) of the cooling target 2 can be efficiently cooled using the refrigerant used for cooling the cooling target 2.

### [Second Example Embodiment]

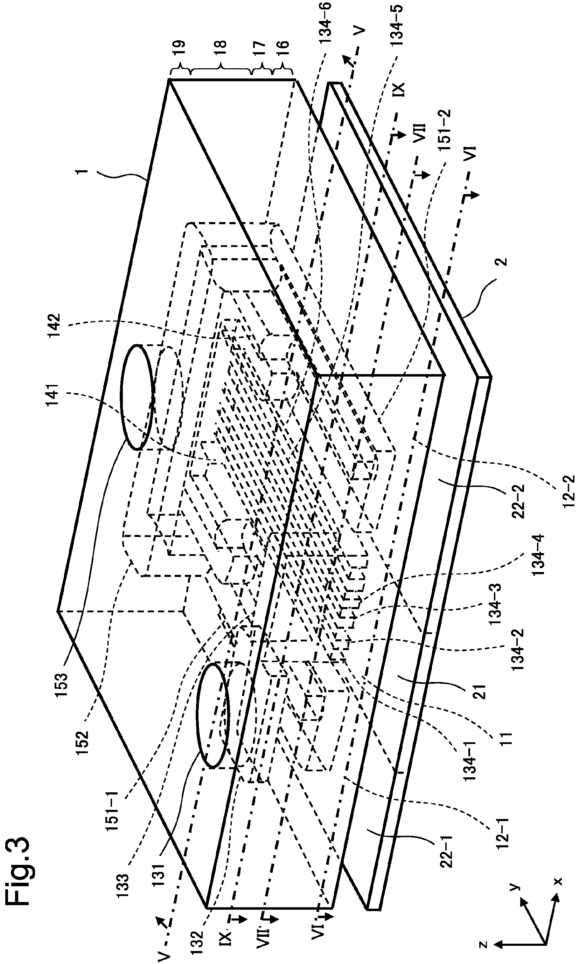

A cooling component 1 according to a second example embodiment of the present disclosure will be described with reference to Figs. 1 to 10. According to the present example embodiment, a specific example of the cooling component 1 in the first example embodiment will be described. The xyz axes illustrated in Figs. 3 to 10 are directed in the same direction as the xyz axes illustrated in Figs. 1 and 2, and thus the description of the directions indicated by the xyz axes is omitted.

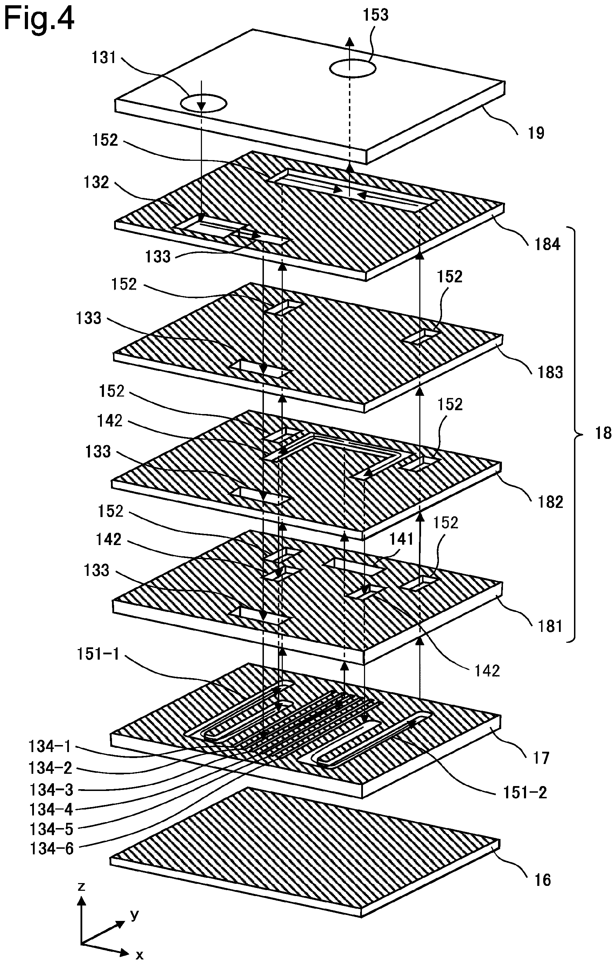

Fig. 3 is a transparent exploded perspective view illustrating a configuration example of a device including the cooling component 1 and a cooling target 2 in the present example embodiment. Fig. 4 is an exploded perspective view of the cooling component 1 illustrated in Fig. 3. The cooling component 1 according to the second example embodiment is formed by sequentially laminating layers formed along the xy plane. Each layer illustrated in Figs. 3 and 4 is an example of a layer formed along the xy plane in the cooling component 1. The arrows in the cooling component 1 in Fig. 4 schematically indicate the direction in which the refrigerant flows.

The configurations of a high-temperature region 21 and another regions 22-1 and 22-2 of a cooling target 2 are similar to the configurations of the high-temperature region 21 and the another regions 22-1 and 22-2 illustrated in Fig. 2, and thus, the common description will be omitted.

The cooling target 2 is, for example, a central processing unit (CPU). The cooling target 2 is, for example, an electronic component such as a semiconductor circuit. Alternatively, the cooling target 2 may be a large-scale integration (LSI) constituting a CPU. The cooling target 2 may be one LSI, or the cooling target 2 may be two or more LSIs. The cooling target 2 may be a memory and a CPU. For example, it is assumed that each of the another region 22-1 and the another region 22-2 is mainly configured by a circuit having a lower heat generation temperature than the high-temperature region 21. It is assumed that the high-temperature region 21 is mainly constituted by a circuit having a higher heat generation temperature than each of the another region 22-1 and the another region 22-2. In Figs. 1 to 10, the cooling target 2 in which one high-temperature region 21 is provided along the y-axis in the central portion of the side parallel to the x-axis direction of the plane parallel to the xy plane is exemplified, but the position of the high-temperature region 21 is not limited to the position illustrated in Figs. 1 to 10. The number of high-temperature region 21 may be two or more.

Figs. 1 to 10 illustrate the cooling target 2 including the two another regions, but the number of the another regions is not limited to two as illustrated in Figs. 1 to 10. The cooling target may include one another region or may include three or more another regions.

As illustrated in Fig. 3, the cooling component 1 may be a multilayer structure in which a heat receiving layer 16, a cooling passage forming layer 17, an intermediate layer 18, and an upper surface layer 19 are sequentially laminated. Alternatively, the cooling component 1 may be formed as an integral body. As illustrated in Fig. 4, the intermediate layer 18 is formed by sequentially laminating a first intermediate layer 181, a second intermediate layer 182, a third intermediate layer 183, and a fourth intermediate layer 184.

The refrigerant passing through the flow passage in the cooling component 1 is, for example, water. The refrigerant may be liquid or gas. When the refrigerant is water, the cooling component 1 is, for example, a cold plate for water cooling. Since water has a larger heat transport amount per unit weight than air, the cooling component 1 using water as a refrigerant can efficiently cool the cooling target 2 as compared with the case of air cooling. For example, the cooling component 1 is mounted in the information device apparatus in order to cool the cooling target 2 in the information processing device. In addition, the device may be configured as a device including the cooling component 1 and the cooling target 2. For example, a device including the cooling component 1 and the cooling target 2 may be mounted in the information processing device.

The cooling component 1 cools the cooling target 2 by receiving heat from the cooling target 2. The configurations of the refrigerant supply passage 13, the connecting passage 14, and the refrigerant discharge passage 15 of the cooling component 1 are similar to the configurations of the refrigerant supply passage 13, the connecting passage 14, and the refrigerant discharge passage 15 illustrated in Figs. 1 and 2, and thus, the common description will be omitted.

Since the configurations of the cooling section 11 and the another cooling sections 12-1 and 12-2 are similar to the configurations of the cooling section 11 and the another cooling sections 12-1 and 12-2 of the cooling component 1 illustrated in Figs. 1 and 2, the common description will be omitted. The positions and the numbers of the high-temperature section and the another sections of the cooling component 1 may be determined by the designer of the cooling component 1 based on the temperature distribution of the cooling target 2.

When a predetermined number of high-temperature regions are included in the cooling target, the cooling component 1 includes the same number of cooling sections facing the high-temperature regions as the number of high-temperature regions. When the cooling target includes a predetermined number of another regions, the cooling component 1 includes the same number of another portions facing the another regions as the number of another regions.

The cooling target 2 is coupled to the heat receiving layer 16 forming the bottom surface of the cooling component 1 via an intervening material. The heat receiving layer 16 receives heat from the cooling target 2. The intervening material is, for example, air that fills a predetermined space between the bottom surface of the cooling component 1 and the cooling target 2. Alternatively, the intervening material is a thermally conductive material. Or, the cooling target 2 may be in direct contact with the heat receiving layer 16 forming the bottom surface of the cooling component 1.

As illustrated in Fig. 4, the cooling passage forming layer 17 includes the upstream-side passages 134-1 to 134-6 of the refrigerant supply passage 13 and the downstream-side passages 151-1 and 151-2 of the refrigerant discharge passage 15. The cooling passage forming layer 17 is disposed on the heat receiving layer 16.

The number of the upstream-side passages 134-1 to 134-6 of the refrigerant supply passage 13, which are passages disposed inside the cooling section 11 facing the high-temperature region 21 of the cooling target 2, is not limited to six as illustrated in Figs. 1 to 4. The number of the upstream-side passages 134-1 to 134-6 may be one, or may be a predetermined number of two or more.

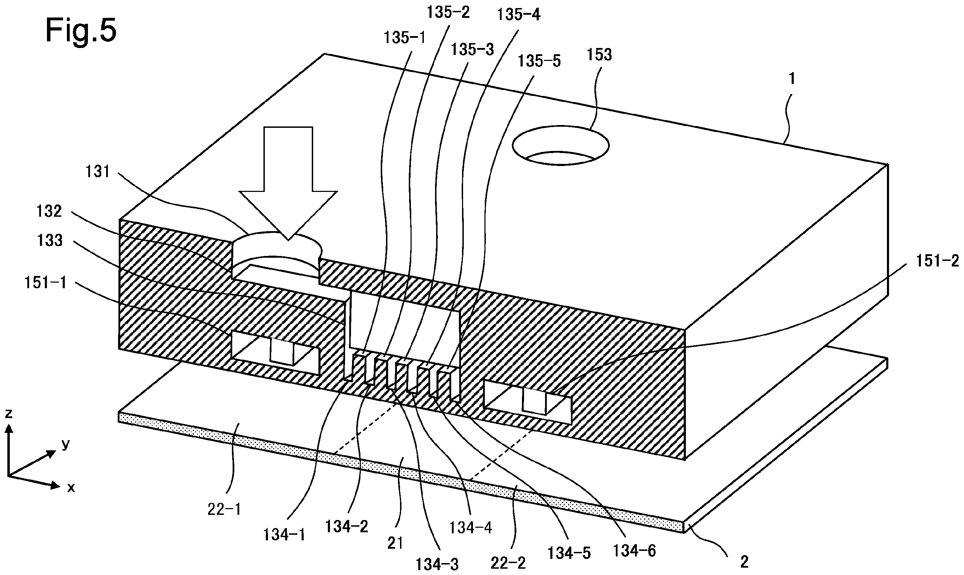

Fig. 5 is a cross-sectional view taken along line V-V of the device illustrated in Fig. 3. Fig. 5 is a cross-sectional view of the device illustrated in Fig. 3 taken along line V-V in Fig. 3 and parallel to the xz plane. The line V-V will be described later. As illustrated in Fig. 5, the upstream-side passage is configured by a plurality of flow passages partitioned by a plurality of plate-like members 135-1 to 135-5 disposed inside the cooling section 11. Each of the plate-like members 135-1 to 135-5 is a part of the cooling passage forming layer 17.

Specifically, the upstream-side passage 134-1 and the upstream-side passage 134-2 are partitioned by the plate-like member 135-1. The upstream-side passage 134-2 and the upstream-side passage 134-3 are partitioned by the plate-like member 135-2. Although not described, the upstream-side passage 134-3 to upstream-side passage 134-6 are similarly partitioned by the plate-like members.

In a case where the cooling target includes a plurality of high-temperature regions, the upstream-side passage may be disposed inside all the cooling sections facing each of the high-temperature regions. Alternatively, when the cooling target includes a plurality of high-temperature regions, the upstream-side passage may not be disposed inside of at least one or more cooling sections facing each of the high-temperature regions.

The shapes of the upstream-side passages 134-1 to 134-6 of the refrigerant supply passage 13 may not be rectangular passages. For example, the upstream-side passages 134-1 to 134-6 may be cylindrical passages. Specifically, the upstream-side passage may be a cylindrical passage in which the central axis of the cylindrical space is arranged in parallel with the y-axis.

The downstream-side passages 151-1 and 151-2, which are passages arranged inside the another cooling sections 12-1 and 12-2, are arranged in parallel adjacent to the upstream-side passages 134-1 to 134-6. Specifically, the downstream-side passage 151-1 is arranged in parallel adjacent to the upstream-side passage 134-1. The downstream-side passage 151-2 is arranged in parallel adjacent to the upstream-side passage 134-6.

The shapes of the downstream-side passages 151-1 and 151-2 are not limited to the shapes illustrated in Figs. 1 to 4. In the example illustrated in Figs. 1 to 4, the downstream-side passages 151-1 and 151-2 has a U-shape in a cross-sectional view of the passage on the xy plane in which the passage is bent once. For example, the downstream-side passages may have a meandering shape in a cross-sectional view of the passage on the xy plane that is bent twice or more at any number of times.

In the example illustrated in Figs. 1 to 4, the downstream-side passages 151-1 and 151-2 have a shape in which three rectangular passages are connected. For example, the downstream-side passages 151-1 and 151-2 may have a shape in which three cylindrical passages are connected.

In a case where the cooling target includes a plurality of another regions, the downstream-side passages may be disposed inside all the another cooling sections. Alternatively, in a case where the cooling target includes a plurality of another regions, the downstream-side passages may not be disposed inside at least one or more another cooling sections.

The intermediate layer 18 is disposed on the cooling passage forming layer 17. The connecting passage 14 is formed in the intermediate layer 18.

In the first intermediate layer 181 of the intermediate layer 18, as illustrated in Fig. 4, the rectangular passage 133 of the refrigerant supply passage 13, the rectangular passage 141 and the U-shaped passage 142 of the connecting passage 14, and the U-shaped passage 152 of the refrigerant discharge passage 15 are formed.

In the second intermediate layer 182, as illustrated in Fig. 4, the rectangular passage 133 of the refrigerant supply passage 13, the U-shaped passage 142 of the connecting passage 14, and the U-shaped passage 152 of the refrigerant discharge passage 15 are formed.

In the third intermediate layer 183, as illustrated in Fig. 4, the rectangular passage 133 of the refrigerant supply passage 13 and the U-shaped passage 152 of the refrigerant discharge passage 15 are formed.

In the fourth intermediate layer 184, as illustrated in Fig. 4, the rectangular passage 132 and the rectangular passage 133 of the refrigerant supply passage 13, and the U-shaped passage 152 of the refrigerant discharge passage 15 are formed.

The rectangular passage 132 and the rectangular passage 133 of the refrigerant supply passage 13, and the rectangular passage 141 of the connecting passage 14 may be formed of cylindrical channels. Each of the U-shaped passage 142 of the connecting passage 14 and the U-shaped passage 152 of the refrigerant discharge passage 15 may be formed by connecting three cylindrical passages.

The upper surface layer 19 is disposed above the intermediate layer 18. As illustrated in Fig. 4, the upper surface layer 19 is provided with the supply port 131 and the discharge port 153.

A method for manufacturing the cooling component 1 will be described. In addition to this method, any method can be used as the method for manufacturing the cooling component 1.

First, a layer having a shape in which the cooling component 1 is cut along the xy plane by a predetermined width in the z-axis direction is manufactured. For example, as illustrated in Fig. 4, the heat receiving layer 16, the cooling passage forming layer 17, the intermediate layer 18, and the upper surface layer 19 are each manufactured using a copper plate. Then, in the cooling component 1, the heat receiving layer 16, the cooling passage forming layer 17, the intermediate layer 18, and the upper surface layer 19 are sequentially bonded by diffusion bonding which is a method of bonding using diffusion of atoms generated between the bonding surfaces.

A case where the cooling component 1 is manufactured by sequentially laminating the heat receiving layer 16 to the upper surface layer 19 will be specifically described. First, the upper surface of the heat receiving layer 16 and the bottom surface of the cooling passage forming layer 17 are bonded by diffusion bonding. Next, the upper surface of the cooling passage forming layer 17 and the bottom surface of the first intermediate layer 181 are joined by diffusion bonding. Although not described, the intermediate layer 18 and the upper surface layer 19 are bonded by diffusion bonding.

When the layers of the cooling component 1 manufactured using the copper plate are bonded by diffusion bonding, atoms of the joint surfaces of the layers of the cooling component 1 diffuse, so that the cooling component 1 is formed as an integrated body.

Although the manufacturing method for manufacturing the cooling component 1 formed of copper has been described, for example, the cooling component 1 is formed of any metal. In addition, in the cooling component 1, when the layers are bonded so that the heat receiving layer 16, the cooling passage forming layer 17, the intermediate layer 18, and the upper surface layer 19 are sequentially bonded, the layers may be bonded in any order.

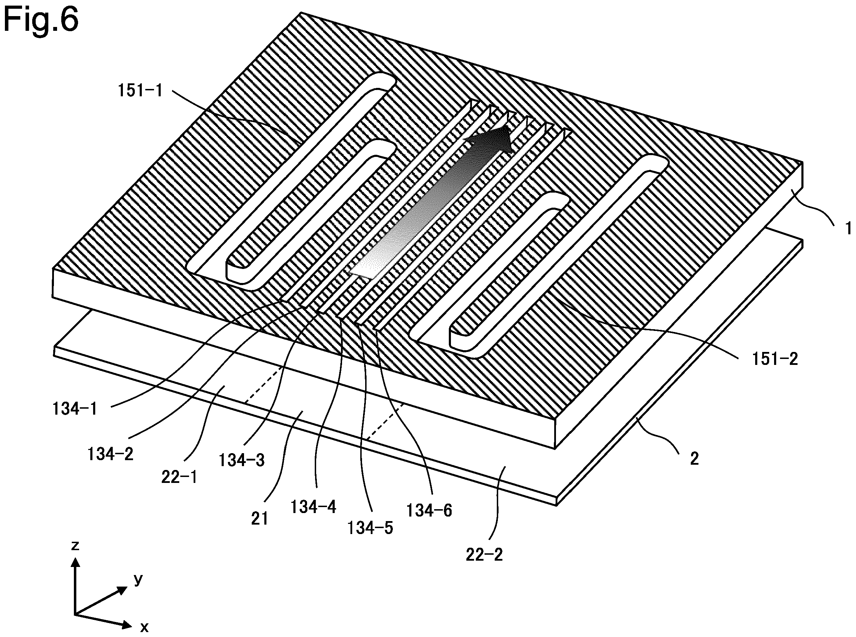

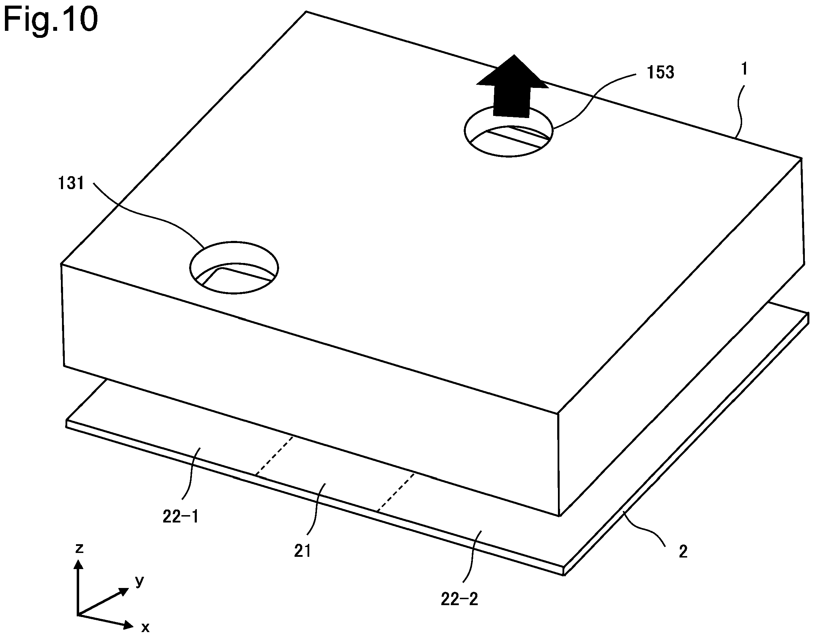

Next, a flow of the refrigerant passing through the cooling component 1 will be described with reference to Figs. 5 to 10. In Figs. 5 to 10, the arrows indicating the flow of the refrigerant passing through the cooling component 1 are illustrated in chronological order. Specifically, in Fig. 5, the refrigerant supplied from the supply port 131 to the cooling component 1 passes through the inside of the cooling component 1 as illustrated in Figs. 6 to 9, and is discharged from the discharge port 153 to the outside of the cooling component 1 in Fig. 10.

The arrows in Figs. 5 to 10 schematically indicate directions in which the refrigerant flows. The colors of the arrows in Figs. 5 to 10 indicate the temperature of the refrigerant. It is indicated that the temperature of the refrigerant indicated by the gray arrows is higher than that of the refrigerant indicated by the white arrows. In addition, it is indicated that the temperature of the refrigerant indicated by the black arrows is higher than that of the refrigerant indicated by the gray arrows. In other words, the temperature of the refrigerant increases in the order of the refrigerant indicated by the white arrows, the refrigerant indicated by the gray arrows, and the refrigerant indicated by the black arrows.

Along the flow of the refrigerant passing through the cooling component 1, first, the flow of the refrigerant passing through the refrigerant supply passage 13 will be described, next, the flow of the refrigerant passing through the connecting passage 14 will be described, and then, the flow of the refrigerant passing through the refrigerant discharge passage 15 will be described.

First, the flow of the refrigerant passing through the refrigerant supply passage 13 will be described.

First, description will be made with reference to Fig. 5. Fig. 5 is a cross-sectional view of the cooling component 1 taken along the line V-V in Fig. 3 and parallel to the xz plane. The line V-V in Fig. 3 is arranged at a position where the supply port 131, the rectangular passage 132, the rectangular passage 133, the upstream-side passages 134-1 to 134-6, the downstream-side passage 151-1, the downstream-side passage 151-2, and the cooling target 2 are cross-cut. In Fig. 5, the arrows indicating the refrigerant passing through the cooling component 1 is not illustrated.

The refrigerant supplied to the supply port 131 has a low temperature as indicated by white arrows in Fig. 5. The refrigerant supplied from the supply port 131 to the rectangular passage 132 passes through the rectangular passage 133 and is discharged to each of the upstream-side passages 134-1 to 134-6.

Fig. 6 is a cross-sectional view taken along the line VI-VI of Fig. 3, illustrating the layered structure below the cooling passage forming layer 17 and the cooling target 2 in the cooling component 1 according to the present example embodiment, and illustrating the direction in which the refrigerant flows in the upstream-side passages 134-1 to 134-6. Fig. 6 is a cross-sectional view of the cooling component 1 taken along the line VI-VI in Fig. 3 and parallel to the xy plane. The line VI-VI in Fig. 3 is disposed at a position cutting the upstream-side passages 134-1 to 134-6 of the refrigerant supply passage 13, the downstream-side passage 151-1 of the refrigerant discharge passage 15, and the downstream-side passage 151-2. In Fig. 6, the arrows indicating the refrigerant passing through the downstream-side passage 151-1 and the downstream-side passage 151-2 are not illustrated.

The refrigerant supplied from the rectangular passage 133 to each of the upstream-side passages 134-1 to 134-6 receives heat from the heat receiving layer 16 while passing through each of the upstream-side passages 134-1 to 134-6 in the positive y-axis direction. Therefore, the temperature of the refrigerant passing through each of the upstream-side passages 134-1 to 134-6 increases as the refrigerant passes through the upstream-side passages 134-1 to 134-6. The color of the arrow indicating the refrigerant passing through the upstream-side passages 134-1 to 134-6 illustrated in Fig. 6 changes from white to black. The color change of the arrow illustrated in Fig. 6 indicates that the temperature of the refrigerant increases as the refrigerant passes through the upstream-side passages 134-1 to 134-6.

The refrigerant that has passed through each of the upstream-side passages 134-1 to 134-6 is discharged to the rectangular passage 141 of the connecting passage 14.

Next, a flow of the refrigerant passing through the connecting passage 14 will be described.

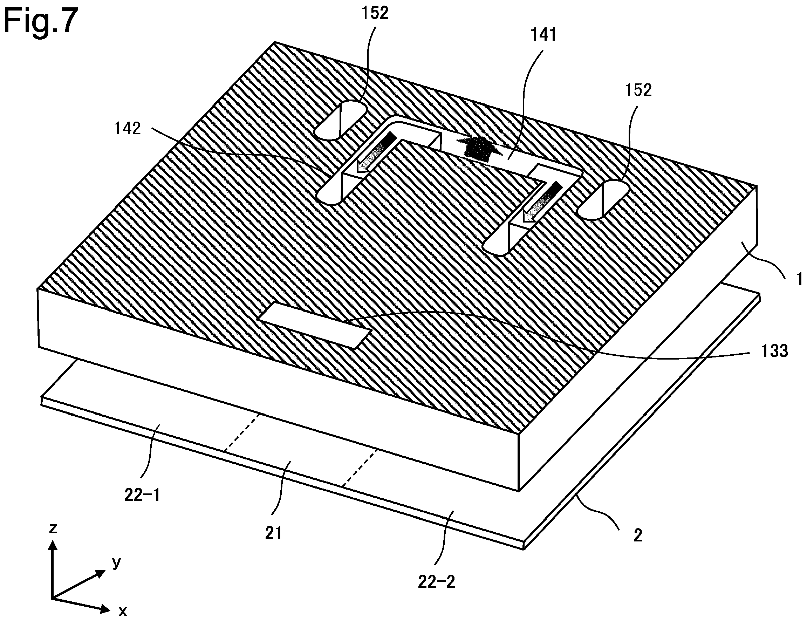

Fig. 7 is a cross-sectional view taken along the line VII-VII of Fig. 3, illustrating the layered structure below the second intermediate layer 182 in the cooling component 1 and the cooling target 2 according to the present example embodiment, and illustrating the direction in which the refrigerant flows in the connecting passage 14. Fig. 7 is a cross-sectional view of the cooling component 1 taken along the line VII-VII in Fig. 3 and parallel to the xy plane. The line VII-VII in Fig. 3 is disposed at a position where the rectangular passage 133 of the refrigerant supply passage 13, the U-shaped passage 142 of the connecting passage 14, and the U-shaped passage 152 of the refrigerant discharge passage 15 are cross-cut. In Fig. 7, the arrows indicating the refrigerant passing through the rectangular passage 133 and the U-shaped passage 152 are not illustrated.

The refrigerant supplied from each of the upstream-side passages 134-1 to 134-6 to the rectangular passage 141 passes through the rectangular passage 141 and is discharged to the U-shaped passage 142. As illustrated in Fig. 7, the refrigerant supplied from the rectangular passage 141 to the U-shaped passage 142 is diverted in two directions.

The intermediate layer 18 in which the U-shaped passage 142 is disposed is lower in temperature than the heat receiving layer 16 and the cooling passage forming layer 17. Therefore, as the refrigerant passes through the U-shaped passage 142, the temperature of the refrigerant is lower than the temperature of the refrigerant when flowing into the U-shaped passage 142 from the rectangular passage 141. The colors of the arrows indicating the refrigerant passing through the U-shaped passage 142 illustrated in Fig. 7 changes from black to white. The change in color of the arrows illustrated in Fig. 7 represents that the temperature of the refrigerant decreases as it passes through the U-shaped passage 142.

The refrigerant having passed through the U-shaped passage 142 is discharged to the downstream-side passage 151-1 or the downstream-side passage 151-2 of the refrigerant discharge passage 15.

Next, a flow of the refrigerant passing through the refrigerant discharge passage 15 will be described.

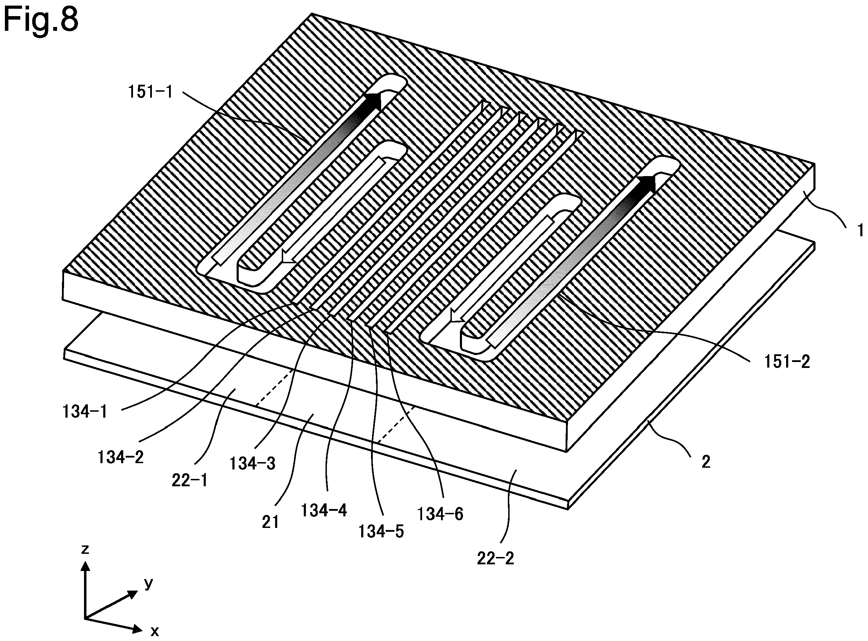

Fig. 8 is a cross-sectional view taken along the line VI-VI of Fig. 3, illustrating the layered structure below the cooling passage forming layer 17 in the cooling component 1 and the cooling target 2 of the present example embodiment, and illustrating the direction in which the refrigerant flows in the downstream-side passages 151-1 and 151-2. Fig. 8 is the same cross-sectional view as the cross-sectional view (Fig. 6) of the cooling component 1 taken along the line VI-VI in Fig. 3 and parallel to the xy plane. Fig. 8 illustrates the arrow indicating the direction in which the refrigerant passes through the downstream-side passage 151-1 and the arrow indicating a direction in which the refrigerant passes through the downstream-side passage 151-2. In Fig. 8, the arrows indicating the refrigerant passing through each of the upstream-side passages 134-1 to 134-6 are not illustrated.

The refrigerant supplied to the downstream-side passage 151-1 passes through the downstream-side passage 151-1 and is discharged to the U-shaped passage 152. The refrigerant supplied to the downstream-side passage 151-2 also passes through the downstream-side passage 151-2 and is discharged to the U-shaped passage 152. As indicated by the white arrows in Fig. 8, the downstream-side passage 151-1 and the downstream-side passage 151-2 are supplied with the refrigerant having a temperature lower than that of the refrigerant passing through the upstream-side passages 134-1 to 134-6 by passing through the connecting passage 14.

In addition, as the refrigerant passes through the downstream-side passage 151-1 or the downstream-side passage 151-2, the refrigerant receives heat from the heat receiving layer 16, so that the temperature of the refrigerant rises. The color of the arrows indicating the refrigerant passing through the downstream-side passage 151-1 and the color of the arrow indicating the refrigerant passing through the downstream-side passage 151-2 illustrated in Fig. 8 change from white to black. The change in color of the arrows illustrated in Fig. 8 indicates that the temperature of the refrigerant increases as it passes through the downstream-side passage 151-1 or the downstream-side passage 151-2.

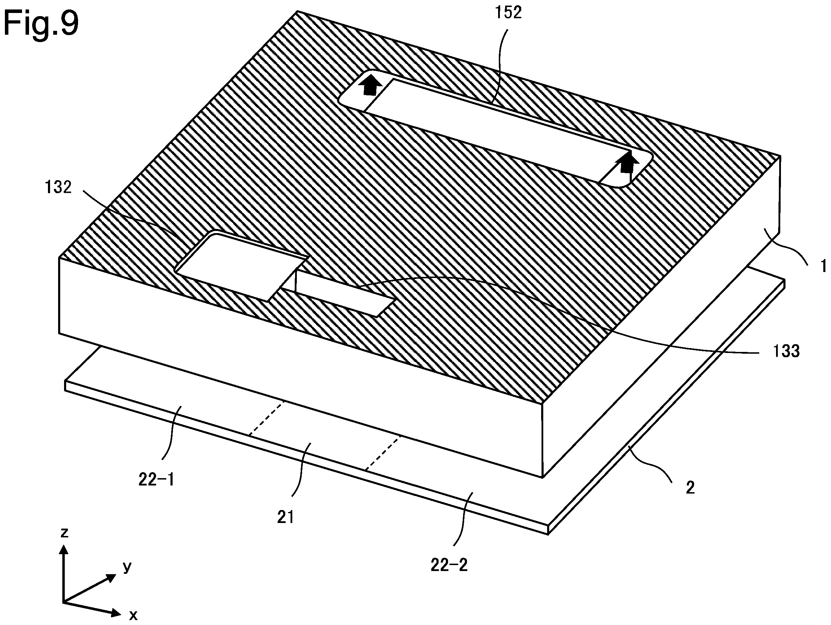

Fig. 9 is a cross-sectional view taken along the line IX-IX in Fig. 3, illustrating the layered structure below the fourth intermediate layer 184 in the cooling component 1 and the cooling target 2 of the present example embodiment, and illustrating the refrigerant flow direction in the refrigerant discharge passage 15. Fig. 9 is a cross-sectional view of the cooling component 1 taken along the line IX-IX in Fig. 3 and parallel to the xy plane. The line IX-IX in Fig. 3 is disposed at a position where the rectangular passage 132 of the refrigerant supply passage 13, the rectangular passage 133, and the U-shaped passage 152 of the refrigerant discharge passage 15 are cross-sectioned. In Fig. 9, the arrows representing the refrigerant passing through the rectangular passage 132 of the refrigerant supply passage 13 and the rectangular passage 133 are not illustrated.

As illustrated in Fig. 9, the refrigerant supplied to the U-shaped passage 152 passes through the U-shaped passage 152 in the positive z-axis direction. The color of the arrows illustrated in Fig. 9 is black, which indicates that the temperature of the refrigerant rises.

Fig. 10 is a three-dimensional view of the device illustrated in Fig. 3. Fig. 10 does not illustrate the arrows indicating the refrigerant supplied to the supply port 131.

The refrigerant having passed through the U-shaped passage 152 is discharged from the discharge port 153 to the outside of the cooling component 1. The color of the arrow illustrated in Fig. 10 is black, which indicates that the temperature of the refrigerant rises.

A refrigerant circulation device (not illustrated in Figs. 1 to 10) is connected between the supply port 131 and the discharge port 153, and the refrigerant is circulated. For example, the refrigerant circulation device cools the refrigerant discharged from the discharge port 153, and then re-supplies the refrigerant to the supply port 131.

As described above, according to the second example embodiment of the present disclosure, the cooling component 1 cools the cooling target 2 including the high-temperature region 21 and the another regions 22-1 and 22-2, and the passage through which the refrigerant supplied from the upstream-side supply port 131 and discharged toward the downstream-side discharge port 153 flows is disposed inside. The cooling component 1 includes the cooling section 11 facing the high-temperature region 21 of the cooling target 2 and the another cooling sections 12-1 and 22-2 facing the another regions 22-1 and 12-2 of the cooling target 2. In the cooling component 1, the passage includes the refrigerant supply passage 13, the connecting passage 14, and the refrigerant discharge passage 15. In the cooling component 1, the refrigerant supply passage 13 includes the upstream-side passages 134-1 to 134-6 arranged inside the cooling section 11, and cools the high-temperature region 21 of the cooling target 2 by the refrigerant supplied from the supply port 131. In the cooling component 1, the connecting passage 14 is connected to the refrigerant supply passage 13. In the cooling component 1, the refrigerant discharge passage 15 includes the downstream-side passages 151-1 and 151-2 disposed inside the another cooling sections 12-1 and 12-2 and connected to the connecting passage 14. In the cooling component 1, the refrigerant discharge passage 15 cools the another regions 22-1 and 22-2 of the cooling target 2 by the refrigerant supplied from the connecting passage 14, and discharges the refrigerant to the discharge port 153. In the cooling component 1, the connecting passage 14 is disposed at a position farther away from the cooling target 2 than the upstream-side passages 134-1 to 134-6. With this configuration, the refrigerant having passed through the upstream-side passages 134-1 to 134-6 passes through the connecting passage 14, and then is supplied to each of the downstream-side passages 151-1 and 151-2 arranged inside the another cooling sections 12-1 and 12-2. The temperature inside the cooling component 1 decreases as the distance from the cooling target 2 increases. The connecting passage 14 is disposed at a position farther away from the cooling target 2 than the upstream-side passages 134-1 to 134-6. Therefore, as the refrigerant passes through the connecting passage 14, the temperature of the refrigerant becomes lower than the temperature of the refrigerant when flowing into the connecting passage 14. Therefore, when a certain region (the high-temperature region 21 in the present example embodiment) of the cooling target 2 is preferentially cooled, the another region (the another regions 22-1 and 22-2 in the present embodiment) of the cooling target 2 can be efficiently cooled using the refrigerant used for cooling the cooling target 2.

### [Modified Example 1 of Second Example Embodiment]

The cooling component according to Modified Example 1 of the second example embodiment includes a cooling member for cooling a cooling section facing a connecting passage outside the cooling component and in a portion facing the connecting passage on an upper surface of the cooling component. The cooling member for cooling the cooling section facing the connecting passage is, for example, a heat sink. In a case where the cooling member is a heat sink, the heat sink may be forcibly air-cooled. The cooling member for cooling the cooling section facing the connecting passage may be formed integrally with the cooling component.

The cooling component according to Modified Example 1 includes the cooling member for cooling the cooling section facing the connecting passage outside the cooling component and in the portion facing the connecting passage on an upper surface of the cooling component. With this configuration, the temperature of the cooling section facing the connecting passage of the cooling component of the present modified example can be made lower than the temperature of the cooling section facing the connecting passage of the cooling component (for example, the cooling component 1 of the first example embodiment) not including the cooling member. Therefore, the cooling component of the present modified example can lower the temperature of the refrigerant passing through the connecting passage than the cooling component not including the cooling member. The cooling component of the present modified example can cool the another region of the cooling target by the refrigerant having a lower temperature than the temperature of the refrigerant passing through the connecting passage of the cooling component not including the cooling member. Therefore, the cooling component of the present modified example can efficiently cool the another region of the cooling target as compared with the cooling component not including the cooling member.

Alternatively, as a substitute for the cooling member, a ventilation hole that receives heat from the connecting passage may be disposed near the connecting passage in the cooling component of the present modified example.

### [Modified Example 2 of Second Example Embodiment]

In the cooling component according to Modified Example 2 of the second example embodiment, the connecting passage is provided in the upper surface layer of the cooling component. The upper surface layer of the cooling component of the present modified example may be forcibly air-cooled, or may include a cooling member for cooling the cooling section facing the connecting passage at a portion outside the cooling component and facing the connecting passage on the upper surface of the cooling component.

Since the upper surface layer is farther from the cooling target than the intermediate layer, the temperature of the upper surface layer is lower than that of the intermediate layer. Therefore, the temperature of the refrigerant passing through the connecting passage of the cooling component of the present modified example is lower than the temperature of the refrigerant passing through the connecting passage of the cooling component (for example, the cooling component 1 according to the first example embodiment) in which the connecting passage is disposed in the intermediate layer. In the cooling component of the present modified example, the temperature of the refrigerant passing through the connecting passage becomes lower than that of the cooling component in which the connecting passage is arranged in the intermediate layer, and the another region of the cooling target can be cooled by the lower-temperature refrigerant. Therefore, the cooling component of the present modified example can more efficiently cool the another region of the cooling target than the cooling component in which the connecting passage is arranged in the intermediate layer.

Each of the above-described example embodiments is a preferred example embodiment of the present invention, and various modifications can be made without departing from the gist of the present invention.

This application is based upon and claims the benefit of priority from Japanese Patent Application No. 2021-102169 filed on June 21, 2021, the disclosure of which is incorporated herein in its entirety by reference.

### Reference Signs List

- 1: cooling component
- 11: cooling section
- 12-1, 12-2: anther cooling section
- 13: refrigerant supply passage
- 131: supply port
- 132: rectangular passage
- 133: rectangular passage
- 134-1 to 134-6: upstream-side passage
- 135-1 to 135-5: plate-like member
- 14: connecting passage
- 141: rectangular passage
- 142: U-shaped passage
- 15: refrigerant discharge passage
- 151-1, 151-2: downstream-side passage
- 152: U-shaped passage
- 153: discharge port
- 16: heat receiving layer
- 17: cooling passage forming layer
- 18: intermediate layer
- 181: first intermediate layer
- 182: second intermediate layer
- 183: third intermediate layer
- 184: fourth intermediate layer
- 19: upper surface layer
- 2: cooling target
- 21: high-temperature region
- 22-1, 22-2: another region

## Claims

1. A cooling component that cools a cooling target including a high-temperature region that rises to a higher temperature by heat generation and another region that rises to a temperature lower than that of the high-temperature region by heat generation, and internally includes a passage through which a refrigerant supplied from an upstream-side supply port and discharged toward a downstream-side discharge port flows, the cooling component comprising:
a cooling section facing the high-temperature region and another cooling section facing the another region, wherein
the passage comprises:
a refrigerant supply passage that includes an upstream-side passage disposed inside the cooling section facing the high-temperature region and cools the high-temperature region by the refrigerant supplied from the supply port;
a connecting passage connected to the refrigerant supply passage; and
a refrigerant discharge passage that includes a downstream-side passage disposed in the another cooling section and connected to the connecting passage, cools the another region with the refrigerant supplied from the connecting passage, and discharges the refrigerant to the discharge port, and
the connecting passage is disposed at a position farther away from the cooling target than the upstream-side passage.

2. The cooling component according to claim 1, wherein
a heat receiving layer that receives heat from the cooling target,
a cooling passage forming layer that is disposed on the heat receiving layer and in which the upstream-side passage and the downstream-side passage are formed,
an intermediate layer disposed on the cooling passage forming layer and in which the connecting passage is formed, and
an upper surface layer disposed on the intermediate layer and provided with the supply port and the discharge port
are sequentially layered.

3. The cooling component according to claim 1 or 2, wherein
the upstream-side passage includes a plurality of passages partitioned by a plurality of plate-like members disposed inside the cooling section facing the high-temperature region, and
the downstream-side passage is arranged in parallel with and adjacent to the upstream-side passage.

4. The cooling component according to any one of claims 1 to 3, wherein
a cooling member for cooling a cooling section facing the connecting passage is provided outside the cooling component and in a portion on an upper surface of the cooling component that faces the connecting passage.

5. A device comprising:
the cooling component according to any one of claims 1 to 4; and
the cooling target.
